# EUROPEAN PATENT APPLICATION

(11) **EP 1 182 792 A1**
(43) Date of publication of application: **27.02.2002**
(21) Application number: 00610083.8
(22) Date of filing: 25.08.2000
(51) Int. Cl.: H04B 1/40

(54) **An electronic circuit for and a method of controlling the output frequency of a frequency synthesizer**

(71) Applicant: Telefonaktiebolaget L M Ericsson (Publ), 126 25 Stockholm (SE)
(72) Inventor: Kunkel, Lars Peter, 261 93 Landskrona (SE)
(74) Representative: Boesen, Johnny Peder

(57) **Abstract**

The invention relates to: An electronic circuit for controlling the output frequency from a frequency synthesizer, said output frequency being based on a reference frequency from a voltage controlled crystal oscillator (VCXO), the latter being regulated by a D/A converter controlled by a processing circuit that monitors a frequency error. The invention further relates to a method and a computer program, a computer readable medium and a dual mode mobile telephone. The object of the present invention is to provide a simple and economic scheme for overcoming the temperature limitations of a VCXO based frequency synthesizer. The problem is solved in that based on said frequency error and predefined conditions said processing circuit generates first and second control signals, for modifying the control voltage to the VCXO to correspondingly change the reference frequency of said VCXO in such a way that the margin to the D/A converter limit is increased, and simultaneously programming the frequency synthesizer in such a way that said frequency change of the VCXO is compensated. This has the advantage of maintaining an almost constant output frequency over an extended temperature by using existing components. The invention may e.g. be used in dual mode systems having different temperature ranges of their specifications and where the system having the wider temperature range has the more relaxed frequency specifications.

## Description

### Technical Field of the Invention:

The invention relates to the control of the output frequency of a frequency synthesizer in extreme temperature conditions using a voltage controlled crystal oscillator (VCXO) as a frequency reference. The invention may e.g. be used in cellular communication systems.

The invention relates specifically to: An electronic circuit for controlling the output frequency from a frequency synthesizer within a specified range of deviation from a predefined output frequency, said output frequency being based on a reference frequency from a voltage controlled crystal oscillator (VCXO), said circuit comprising a processing circuit having means for monitoring a frequency error and a D/A converter for converting a digital output from said processing circuit to an analog input to said VCXO.

The invention furthermore relates to: A method of controlling the output frequency from a frequency synthesizer within a specified range of deviation from a predefined output frequency, said output frequency being based on a reference frequency from a voltage controlled crystal oscillator (VCXO), and the reference frequency of said VCXO being regulated by a processing circuit that monitors a frequency error and a D/A converter for converting a digital signal from said processing circuit to an analog input to said VCXO.

The invention furthermore relates to: A computer program comprising computer program means.

The invention moreover relates to: A computer readable medium having a program recorded thereon.

The invention moreover relates to: A dual mode cellular telephone.

### Description of Related Art:

A frequency synthesizer generates an output frequency, which is a multiple of a reference frequency, which could be derived from e.g. a VCXO. A common type of frequency synthesizer consists of a phase-locked loop, including a phase detector, a loop filter and a voltage controlled oscillator (VCO) and a feedback path of the VCO output to the input of the phase detector to adjust the phase of the VCO output to that of the reference frequency. By subdividing the VCO output frequency in the feed back loop by means of a programmable divider, the VCO output frequency (and thus the synthesizer output frequency) may be controlled in multiples of the input reference frequency. The step size of the frequency changes is controlled by the divisor N of the programmable divider. If N is an integer (i.e. if the divider is an integer divider), the smallest step size equals the input reference frequency. If on the other hand N is a rational number (i.e. if the divider is a fractional-N divider), a finer step size may be achieved without using a lower input reference frequency.

The frequency f_{VCXO} of a VCXO can be changed by changing its capacitive load C_{load}, i.e. f_{VCXO}=g(C_{load}), where g indicates a functional dependence. The change of the capacitive load may be implemented in a number of ways, e.g. using a varactor diode that acts as a voltage-variable capacitor, which changes its capacitance C_{load} in response to the applied input voltage Vᵢₙ, i.e. C_{load}=h(Vᵢₙ). The voltage control of the output frequency of the VCXO may conveniently be implemented by a processing circuit, e.g. a micro computer, using an n-bit digital to analog (D/A) converter to change the input voltage Vᵢₙ to the varactor diode of the VCXO in steps, i.e. Vᵢₙ=V_{D/A}=k(N), N=[0..2ⁿ-1], where n indicates the number of bits in the D/A converter. The output frequency of the VCXO is temperature dependent (comprising contributions from the crystal and the varactor diode, etc.), i.e. f_{VCXO}=m(Vᵢₙ,T). The temperature dependency may be recorded in advance (either in the form of a look up table or a polynomial description) and stored in a memory accessible to the micro controller, as can the relationship between a given step of the D/A converter output voltage dV_{D/A} and the resulting change df_{VCXO} in the VCXO output frequency at any given temperature T. In other words a table (or a calculation formula) of the frequency change per D/A converter step for the relevant temperatures of the specified temperature range can be recorded and made available for the processing circuit. Typically the VCXO-circuit is designed so that the frequency change of the VCXO as a function of temperature and per unit voltage input is nearly constant over the operating temperature range and the D/A-converter range (so that the frequency change caused by a given number of D/A converter steps can easily be predicted by the processing circuit). This means, on the other hand, due to the characteristics of a typical crystal oscillator (which has a steeper frequency vs. temperature dependence at extreme temperatures) that the number of D/A converter steps needed to keep the VCXO frequency constant increases per unit temperature shift as the operating temperature gets close to or exceeds the intended operating range. So when the regulation circuit is optimized to a certain operating temperature range to yield a specific maximum frequency change per D/A converter voltage step, the number of D/A converter steps available for regulation may not suffice as the operating temperature exceeds the intended operating range.

The following account of the prior art relates to one of the areas of application of the present invention, cellular telephone systems, and particularly to AMPS/GSM1900 dual mode telephones.

AMPS = Advanced Mobile Phone Service is a standard for an analog cellular telephone network used primarily in America and Asia, whereas GSM = Group Special Mobile (or Global System for Mobile communication) is a standard for a digital cellular telephone network used in Europe and many other countries worldwide. GSM1900 refers to a GSM based system utilizing a frequency range around 1900 MHz (actually 1850-1910 MHz paired with 1930-1990 MHz). Other GSM systems are GSM400, GSM900 and GSM1800. AMPS is operated in the frequency around 850 MHz (specifically between 824 and 894 MHz).

In dual band/dual mode mobile telephones, there are in some cases conflicting demands between the two modes of operation with regard to the accuracy and temperature range of the frequency reference oscillator of the phone. For example in an AMPS/GSM1900 dual mode phone, the temperature range in the AMPS mode is -30 to +60 deg. C, and in the GSM1900 mode -10 to +55 deg. C, whereas the frequency accuracy requirement in AMPS mode is ±2.5 ppm, and in the GSM1900 mode ±0.1 ppm (the requirements being defined relative to the frequency *transmitted* from the mobile telephone). Since crystals normally have a very steep frequency vs. temperature characteristics at extreme temperatures, the pulling range for the VCXO arrangement needs to be extended compared to a single band GSM1900 phone without any relaxation on the step size.

US-A-5,703,540 discloses a VCXO circuit with an improved frequency pulling range achieved by using two different programmable integer dividers in the phase locked feedback loop (PLL). The circuit is not used for increasing the temperature range though.

US-A-5,493,700 discloses an automatic frequency control (AFC) system for a radio telephone. Two fractional-N dividers are used in the PLL yielding a relatively complex solution with a corresponding relatively high power consumption.

US-A-5,856,766 discloses a radio communications device, where a reference signal from a crystal oscillator is adjusted by a high resolution local oscillator frequency synthesizer. The temperature and frequency compensated output from this is used as a frequency reference for the remaining local oscillator frequency synthesizers having a more relaxed resolution. I.e. two frequency synthesizers (e.g. PLLs) are used, one referencing the other, again a relatively complex solution.

Today, the solutions to the problem are:
1. To use a digital to analog (D/A) converter with more steps (more bits) to extend the pulling range without sacrificing step size.
2. To use a crystal with a better temperature characteristic that allows a wider temperature range within the pulling range.
3. To temperature compensate the crystal characteristic.
4. To use more complex circuits with more components (dividers, frequency synthesizers, etc.).

### Summary:

The shortcomings of the above solutions are:
1. A D/A converter with finer resolution is more expensive.
2. A crystal with sufficiently good frequency characteristic is much more expensive.
3. To temperature compensate the crystal characteristic is complicated and requires more building area. It also increases the total cost of the product.
4. The use of more components increases cost and power consumption and printed circuit board (PCB) and/or chip area.

In summary, the problems of the prior art result in increased cost, complexity and power consumption.

The solution to the above problems, which in the present example occur when the mobile telephone is in AMPS mode, is to use the PLL to slightly offset the VCOs and use the phone's built-in AFC to compensate for the offset by adjusting the crystal frequency (the AFC attempts to adjust the local reference frequency, e.g. from a VCXO, to match the equivalent frequency of the received signal) . This can be achieved if the PLL can be controlled in sufficiently fine steps, which could be accomplished for example by using a fractional-N PLL in the feedback loop of the PLL.

The principle can be illustrated by the following example. Assuming there is a dual mode AMPS/GSM1900 phone using a cost efficient VCXO design from a single band GSM1900 design. If the operating temperature inside the phone is high and increases, the free running frequency of the crystal increases. This is sensed by the AFC algorithm, which via the D/A converter increases the capacitive load of the crystal so as to keep the frequency constant. Now, if the phone is operating in the AMPS mode where the phone is required to be operable at higher ambient temperatures than the original VCXO design was designed for, it is possible that the D/A converter at some point reaches its limit when operating in extreme temperatures (this is not unlikely to occur because AMPS operates in CW mode as opposed to burst mode as in GSM, which results in higher internal power dissipation). When the limit is reached, it is no longer possible to compensate for the temperature behavior of the crystal, and the output frequency of the VCXO, and hence of the frequency synthesizer, will start to drift (in the case of a high extreme temperature, the frequency will increase for a typical VCXO-design used in mobile telephones). The D/A compensation value (i.e. the specific input value between 0 and 2ⁿ-1 to the D/A converter corresponding to a specific absolute output voltage of the D/A converter) is a known parameter in the phone, which may be stored in a register of the processing unit for further use. When the compensation value gets close to the limit (0 or 2ⁿ-1 corresponding typically to D/A converter output voltages of 0 V and the supply voltage of the circuit, respectively), the following will happen: The PLL is re-programmed to make a small frequency step downwards (e.g. by changing the divisor of a fractional-N divider), while at the same time the D/A compensation value is adjusted for this step (i.e. increasing the margin to the limit). The frequency step should be in the order of a couple of kilohertz. The AFC will take care of any remaining frequency error after the step. The opposite will happen if the telephone is operating under extreme cold conditions. The phone's software will determine when the phone should leave this mode of operation based on different parameters such as temperature, time elapsed since the initial step, and margin to the A/D converter limit.

The object of the present invention is to provide an alternative scheme of overcoming the temperature limitations of a VCXO when used for controlling the output frequency of a frequency synthesizer, which method is simple and economic in implementation.

This is achieved according to the invention in that based on said frequency error and predefined conditions said processing circuit generates first and second control signals, for simultaneously
modifying the control voltage to the VCXO by means of said D/A converter to correspondingly change the reference frequency of said VCXO in such a way that the margin to the D/A converter limit is increased, and
programming the frequency synthesizer in such a way that said frequency change of the VCXO is compensated, leaving said output frequency from said frequency synthesizer basically unaltered.

In the present text, the term 'D/A converter limit' is taken to mean 0 and 2ⁿ-1 for an n-bit D/A converter, 2ⁿ being the maximum number of steps for the D/A converter in question.

In the present text, the term 'frequency synthesizer' is taken to mean a circuit that from a reference input frequency creates an output frequency that may be regulated in steps, e.g. controlled by a processing circuit.

In the present text, the term 'the frequency error' is taken to mean the difference between an intended frequency and the corresponding actual frequency.

In the present text, the term 'predefined conditions' refers to criteria for activating the regulation according to the invention, such as whether the D/A converter is close to or coincide with of its limits (and if so, which one).

An advantage of the invention is that it maintains an almost constant output frequency over an extended temperature range (e.g. within 0,5 ppm of the intended output frequency) by using existing components. In the case of a dual mode system, where a solution for the system having the narrowest temperature range of its specifications is at hand, and where the system having the widest temperature range has the most relaxed frequency specifications, the present invention yields an economically attractive solution.

In a preferred embodiment, said frequency synthesizer is implemented as a fractional-N phase locked loop (PLL). This has the advantage that a finer and programmable step size may be achieved without using a lower input reference frequency compared to a phase locked loop using an integer divider in its feedback loop.

An important merit of the invention is that in an AMPS/GSM1900 dual mode cellular telephone, where the frequency synthesizer in the form of a fractional-N PLL preferably is used anyway, the objects of the invention can be implemented without any hardware changes (except maybe component values) and thus without any cost impact, and the cost efficient VCXO design from the single band GSM1900 design can be used for AMPS mode operation over an extended temperature range.

A fractional-N PLL is a special PLL-based frequency synthesizer, which is able to step the output frequency in fractions of the comparison frequency (e.g. 1/5 or 1/8, although higher resolution fractional-N PLLs are possible), whereas a 'normal' PLL steps in integer values of the comparison frequency.

In a dual mode AMPS/GSM1900 phone, the main synthesizer is preferably designed using a fractional-N PLL, where the 13 MHz reference is divided down to 50 kHz in the AMPS mode for the phase comparator, and the channel steps hence will be 3/5-th of the comparison frequency. The smallest frequency step possible with this set-up is 1/5 times 50 kHz which equals 10 kHz, which most likely is too much to allow a sufficiently small frequency change and still comply with the specifications. If instead the 13 MHz reference is divided down to 40 kHz in AMPS mode, and fractions of 8 rather than 5 is used, the channel steps will be 6/8-th of the comparison frequency and the smallest possible step size will be 1/8 times 40 kHz resulting in 5 kHz which is useful.

When said reference frequency of said VCXO is 13 MHz or a multiple hereof, the construction of a GSM mobile telephone is facilitated.

A method of controlling the output frequency from a frequency synthesizer within a specified range of deviation from a predefined output frequency, said output frequency being based on a reference frequency from a voltage controlled crystal oscillator (VCXO), and the reference frequency of said VCXO being regulated by a processing circuit that monitors a frequency error and a D/A converter for converting a digital signal from said processing circuit to an analog input to said VCXO is furthermore provided by the present invention. When said method comprises the steps of
modifying the control voltage to the VCXO by means of said D/A converter to correspondingly change the reference frequency of said VCXO in such a way that the margin to the D/A converter limit is increased, and simultaneously
programming said frequency synthesizer in such a way that said frequency change of the VCXO is compensated,
said adjustment of the reference frequency from the VCXO and said programming of said frequency synthesizer are controlled by and based on signals from said processing circuit, said signals depending on said frequency error and predefined conditions, it is ensured that an almost constant output frequency over an extended temperature range is provided.

In a preferred embodiment, the method of adjusting the VCXO frequency upwards comprises the steps of
Step SI0: START 'Increase VCXO frequency' procedure.
Step SI1: Can the VCXO frequency be increased more?
Step SI2: Increase the VCXO frequency.
Step SI3: Is Freq_shifted_down flag set?
Step SI4: Is the margin sufficient to reset the frequency shift?
Step SI5: Program the PLL for a frequency shift upwards.
Step SI6: Compensate for the PLL frequency shift by decreasing the VCXO frequency by the appropriate amount.
Step SI7: Reset Freq_shifted_down flag.
Step SI8: Is Freq_shifted_up flag set?
Step SI9: Program the PLL for a frequency shift upwards.
Step SI10: Compensate for the PLL frequency shift by decreasing the VCXO frequency by the appropriate amount.
Step SI11: Set Freq_shifted_up flag.
Step SI12: END of 'Increase VCXO frequency' procedure.

The above steps should be executed in the case of the AFC detecting that the reference frequency is too low and the processing circuit has determined that there is a need for correction.

In a preferred embodiment, the method of adjusting the VCXO frequency downwards comprises the steps of
Step SD0: START 'Decrease VCXO frequency' procedure.
Step SD1: Can the VCXO frequency be decreased more?
Step SD2: Decrease the VCXO frequency.
Step SD3: Is Freq_shifted_up flag set?
Step SD4: Is the margin sufficient to reset the frequency shift?
Step SD5: Program the PLL for a frequency shift downwards.
Step SD6: Compensate for the PLL frequency shift by increasing the VCXO frequency by the appropriate amount.
Step SD7: Reset Freq_shifted_up flag.
Step SD8: Is Freq_shifted_down flag set?
Step SD9: Program the PLL for a frequency shift downwards.
Step SD10: Compensate for the PLL frequency shift by increasing the VCXO frequency by the appropriate amount.
Step SD11: Set Freq_shifted_down flag.
Step SD12: END of 'Decrease VCXO frequency' procedure.
The above steps should be executed in the case of the AFC detecting that the reference frequency is too high and the processing circuit has determined that there is a need for correction.

A computer program comprising computer program means is moreover provided by the present invention. When said computer program means are adapted to perform all the steps of claim 4 when said program is run on a computer, it is ensured that an almost constant output frequency over an extended temperature range is provided when said program is run on a computer such as the micro controller of the electronic circuit outlined in claim 1.

In a preferred embodiment, said computer program means are adapted to perform all the steps of claims 5 and 6 when said program is run on a computer.

A computer readable medium having a program recorded thereon is moreover provided by the present invention. When said program when executed is to make the computer execute the method according to claim 4, it is ensured that an almost constant output frequency over an extended temperature range is provided when said program stored on said computer readable medium is run on a computer such as the micro controller of the electronic circuit outlined in claim 1.

A dual mode cellular telephone is moreover provided by the present invention. When it comprises an electronic circuit according to claims 1-3, it is ensured that the frequency specifications of the two communications systems comprising the two possible modes of the telephone may be fulfilled in a cost effective manner.

### Brief Description of the Drawings:

The invention will be explained more fully below in connection with a preferred embodiment and with reference to the drawings in which:
fig. 1 shows a block diagram of the for the invention essential parts for implementing the AMPS mode of a dual mode GSM/AMPS transceiver according to the invention,
fig. 2 shows a flow chart for the steps according to the invention involved in keeping the output frequency constant when the AFC and the micro controller detects a general need for tuning the VCXO frequency upwards,
fig. 3 shows a flow chart for the steps according to the invention involved in keeping the output frequency constant when the AFC and the micro controller detects a general need for tuning the VCXO frequency downwards, and
fig. 4 shows a typical graph of the relative frequency change versus temperature for an uncompensated crystal oscillator or a VCXO at a constant control voltage.

The figures are schematic and simplified for clarity, and they just show details, which are essential to the understanding of the invention, while other details are left out.

### Detailed Description of Embodiments:

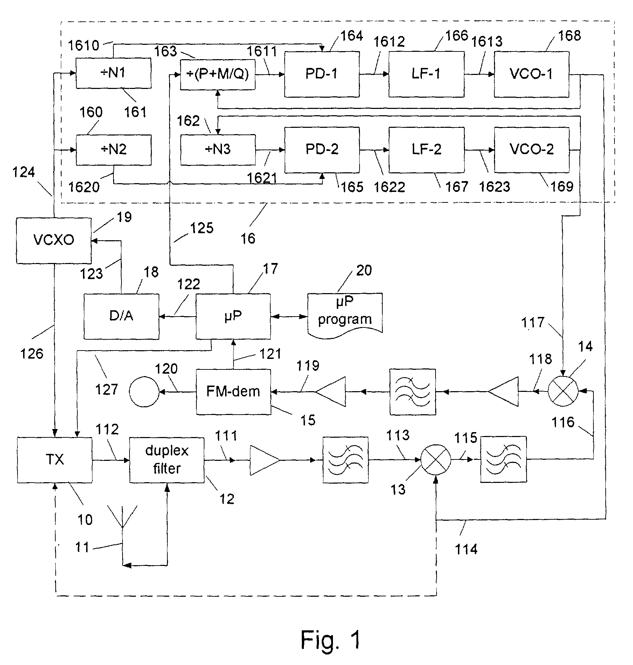

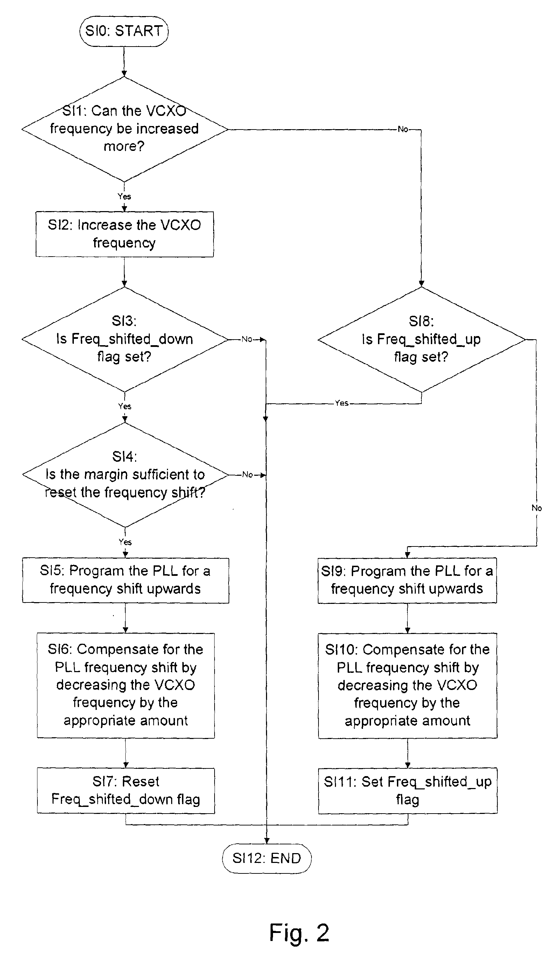

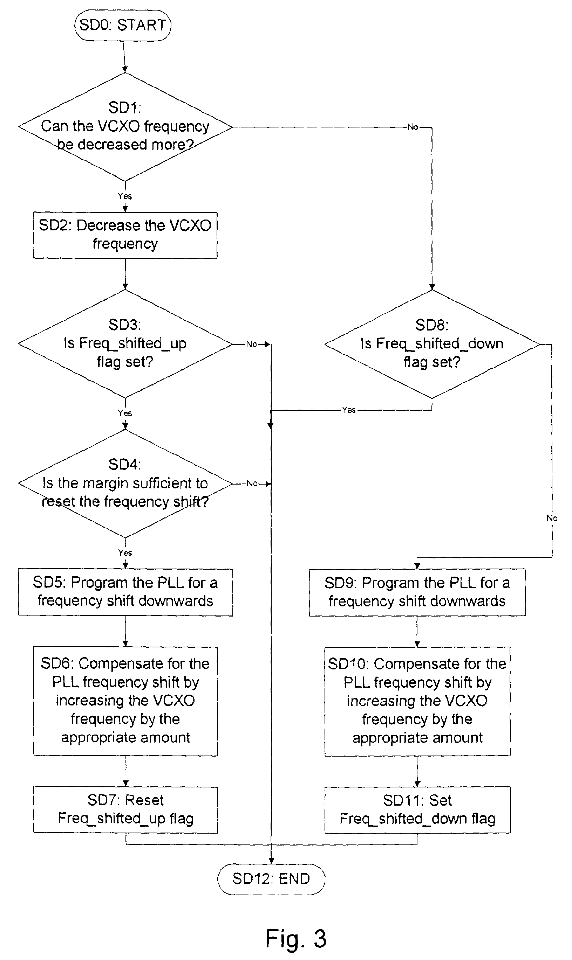

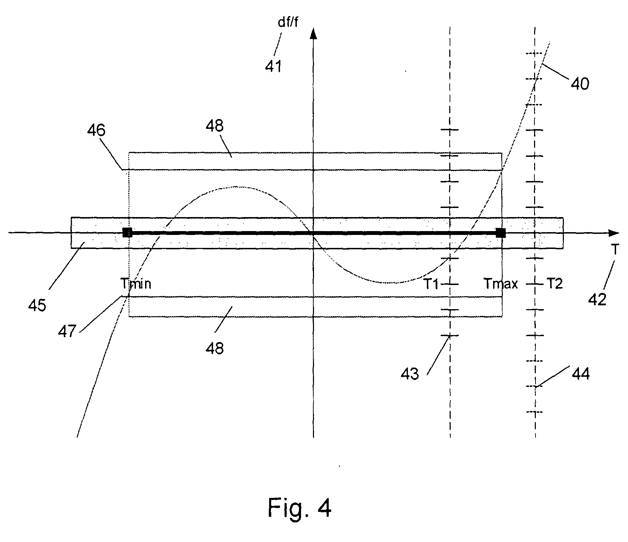

The invention will now be described with reference to the block diagram in fig. 1 and to the flow charts in figs. 2 and 3 and the sketch in fig. 4.

Fig. 1 shows a block diagram of the for the invention essential parts for implementing the AMPS mode of a dual mode GSM/AMPS transceiver according to the invention. Fig. 1 represents one example of an implementation of parts of such a transceiver focused on the receiver part.

The antenna 11 receives and transmits the radio frequency (RF) signal. A duplex filter 12 performs the separation between the received 111 and the transmitted 112 signals.

The transmitter part 10 providing the transmitted signal 112 to the duplex filter 12 is not shown in further detail. The received signal 111 is amplified and filtered to provide the signal 113 containing the receiver frequency band for the cellular telephone in question, e.g. the AMPS frequency band allocated around 850 MHz, before entering a first mixer 13 that mixes the relevant part of the frequency band down in a first intermediate frequency band, using a first local oscillator (LO) frequency 114 for the down-conversion. The first intermediate frequency signal 115 is filtered and the resulting signal 116 is fed to a mixer 14 that mixes the relevant part of the frequency band down in a second intermediate frequency band, using a second local oscillator (LO) frequency 117 for the down-conversion. The second intermediate frequency signal 118 is amplified, filtered and amplified again providing the signal 119 entering the FM Demodulator 15 that retrieves the frequency modulated information from the signal 119 and outputs a signal 120 for further processing.

The first and second local oscillator signals 114 and 117, respectively, are generated by a frequency synthesizer in the form of a phase locked loop 16 comprising dividers 160, 161, 162, 163, phase detectors 164, 165, loop filters 166, 167 and VCOs 168, 169.

A signal 121 representing information on the frequency error of the VCXO is continuously received by the micro controller 17 from the FM demodulator 15. The frequency error is compensated by tuning the reference frequency 124 from the VCXO 19. This is prior art.

In the present invention, the normal mode of operation is as above.

However, in extreme temperature situations where there is a risk of reaching the limits of the tuning range of the VCXO 19, this invention will present a solution. The reason for reaching the limits may be several different, one being the contradictory requirements of, when operating in one system or mode, needing a wide tuning range and, when operating in another system or mode, a fine step size, which otherwise would result in the need for a more expensive D/A-converter 18 with finer resolution (=more bits).

A preferred embodiment of the invention includes a PLL (phase locked loop) 16 being able to tune the VCO 168 in finer steps than the channel spacing of the system in which the unit operates. This type of PLL could preferably be of fractional-N type, as depicted in fig. 1, and could very well be necessary to use anyway, as for instance in dual mode mobile telephones (no cost penalty as a fractional-N PLL normally is more expensive).

The task of the PLL is to create first 114 and second 117 local oscillator (LO) frequency signals on the basis of a reference frequency signal 124 and a PLL control signal 125 for controlling the PLL.

The PLL circuit 16 receives the reference frequency signal 124 from the VCXO 19. The reference frequency 124 is subdivided by N1 and N2 by integer dividers 161, 160 providing first and second subdivided reference frequencies 1610 and 1620, respectively.

The first subdivided reference frequency 1610 from integer (N1) divider 161 is fed to the reference input of a first phase detector 164 for regulating the first LO frequency signal 114. The second input 1611 to the phase detector 164 is the output of a fractional-N divider 163 (N=P+M/Q, P, M, Q being integers (Q≠0), e.g. M=[0, 1, 2, 3, 4, 5, 6, 7], Q=8) subdividing the first LO frequency signal 114 from a first VCO 168 to a frequency corresponding to the subdivided reference frequency 1610. The two inputs to the phase detector 164 are compared and a signal 1612 representing the phase difference between the two inputs 1610 and 1611 is fed to a first loop filter 166, from which the control voltage 1613 to the VCO 168 is provided. The detailed division of the fractional-N divider 163 is governed by control signal 125 from the micro controller 17 and based on the desired output frequency of the VCO 168. The divisors N1, N2, N3 of dividers 161, 160, 162, respectively, are likewise controlled by the micro controller 17 via control signal 125 (connections not shown), and may e.g. be set at power-up of the system or at any other convenient point in time.

The second subdivided reference frequency 1620 from integer (N2) divider 160 is fed to the reference input of a second phase detector 165 for regulating the second LO frequency signal 117. The second input 1621 to the phase detector 165 is the output of an integer (N3) divider 162 subdividing the second LO frequency signal 117 from a second VCO 169 to a frequency corresponding to the subdivided reference frequency 1620. The two inputs to the phase detector 165 are compared and a signal 1622 representing the phase difference between the two inputs 1620 and 1621 is fed to a second loop filter 167, from which the control voltage 1623 to the VCO 169 is provided.

In a preferred embodiment, where the circuit is employed in a dual mode AMPS/GSM1900 telephone, the reference frequency 124 from the VCXO is 13 MHz. Other special embodiments may use a multiple of 13 MHz (e.g. 26 MHz, 39 MHz, etc.).

The following example presumes a reference frequency 124 from the VCXO of 13 MHz, a first intermediate frequency (IF) 115 of 72 MHz and a second IF 118 of 450 kHz and the transmission (TX) and reception (RX) occur in the lowest channel of the AMPS band (channel 991, i.e. TX at 824.04 MHz and RX at 869.04 MHz and a first LO frequency 114 of 941.04 MHz).

The first subdivided reference frequency 1610 from integer divider 161 is 40 kHz, i.e. the reference frequency 124 from the VCXO is divided by 325 (N1=325). The first LO frequency 114 for the receive band of an AMPS system is in the range 941.04-965.97 MHz. To subdivide e.g. 941.04 MHz to 40 kHz, the fractional-N divider 163 (N=P+M/Q) must be programmed to divide by 23526 (i.e. P=23526, M=0).

The second subdivided reference frequency 1620 from integer divider 160 is 10 kHz, i.e. the reference frequency 124 from the VCXO is divided by 1300 (N2=1300=4*325). The second LO frequency 117 for a channel of the receive band of an AMPS system is 71.55 MHz. To subdivide 71.55 MHz to 10 kHz the integer divider 162 must divide by 7155.

In a typical VCXO design for a mobile telephone, VCXO frequency increases with increasing temperature at high temperatures, and VCXO frequency decreases with decreasing D/A converter value. If e.g. the temperature in the telephone is close to the upper limit and increases so that the D/A converter 18 approaches its limit, in other words if e.g. the VCXO is close to the lower control limit and the temperature changes so that the D/A converter would have to exceed its limit to keep the VCXO frequency constant, this is sensed by the micro controller 17 (because the present state and the limits of the D/A converter is known by the micro controller). Consequently the fractional-N divider 163 is programmed by the signal 125 from the micro controller 17 to divide by 23525.875 (i.e. P=23525, M=7, Q=8) instead of 23526.0 (P=23526, M=0). A frequency error of 5 kHz (40/8 kHz) is thus introduced in the loop and detected by the automatic frequency control (AFC) circuit (cf. above) resulting in a 'wish' to increase the VCXO reference frequency 124 correspondingly. In the process of increasing the VCXO frequency, the steps of fig. 2 are executed a corresponding number of times. When the VCXO frequency is increased, the margin to the lower limit of the D/A converter is increased. However, if a simultaneous regulation in opposite direction of the VCXO 19 and VCO 168 output frequencies (signals 124 and 114, respectively) by means of control signals 122 and 125 from the micro controller 17 is performed, it is ensured that the D/A converter 18 (and thus the VCXO 19) is kept within its tuning range AND that the VCO frequency is kept substantially constant throughout the frequency regulation process described above. The signal 125 from the micro controller 17 changes the division ratio of the fractional-N divider 163 as described above resulting in a change of frequency of the subdivided signal 1611 by a multiple of 5 kHz. The signal 122 from the micro controller 17 changes the output voltage 123 of the D/A converter 18 to achieve a corresponding change of the VCXO 19 (but in the opposite direction) based on a known frequency change of the VCXO per step of the D/A converter. Any remaining frequency error is compensated by the AFC.

The invention includes a function to offset the PLL from its normal division ratio, which would have tuned the VCO to the desired frequency. When such an offset is made, the micro controller has to keep track of it. Hence, two flags are needed. One, if an offset step is made to a higher frequency, and one, if a step is made to a lower frequency, as illustrated in figs. 2 and 3. This is, however, only one of several possible ways of implementing it.

The flow charts in figs. 2 and 3 will now be discussed in detail. They show how the compensation according to the invention could be implemented in a mobile telephone. The algorithms presented in figs. 2 and 3 should be run whenever the micro controller software (20 in fig. 1) detects a frequency error that needs to be corrected for. The flow charts in figs. 2 and 3 are essentially identical, the difference being in which direction a frequency change is made.

The described algorithms will replace the events taking place in an AFC (automatic frequency control) algorithm in prior art when the VCXO frequency should be increased (fig. 2) or decreased (fig. 3), respectively.

It is assumed that, when entering the AMPS mode (i.e. prior to the first execution of either of the process steps of the flow charts of figs. 2 or 3), both the Freq_shifted_down flag and the Freq_shifted_up flag are reset AND that the PLLs are programmed to their normal frequencies.

Fig. 2 shows a flow chart for the steps according to the invention involved in keeping the output frequency constant when the AFC and the micro controller detects a general need for tuning the VCXO frequency upwards.

### Step SI0: START 'Increase VCXO frequency' procedure.

This step initializes the 'Increase VCXO frequency' procedure. The algorithm is entered when information about the frequency error received by the micro controller meets the criteria (e.g. a predefined value of the size of the frequency error) for increasing the VCXO frequency.

### Step SI1: Can the VCXO frequency be increased more?

First, a check is made whether the VCXO frequency can be increased by the intended number of D/A-converter steps without reaching the limit of the D/A converter. If yes, continue in step SI2. If no, go to step SI8.

### Step SI2: Increase the VCXO frequency.

The VCXO frequency is increased as intended. Continue in step SI3.

### Step SI3: Is Freq_shifted_down flag set?

A check is made whether the PLL has been offset downwards. If yes, continue in step SI4. If no, go to END of routine (step SI12).

### Step SI4: Is the margin sufficient to reset the frequency shift?

A check is made whether it is time to reset this offset shift, i.e. if the margin to the lower limit has increased enough. If the margin is large enough, the offset will be reset (cf. steps SI5-SI7). If not, go to END of routine (step SI12).

When a VCXO frequency increase is to be made, the following steps are performed (SI5-SI7):

### Step SI5: Program the PLL for a frequency shift upwards.

The PLL is programmed to a small upwards offset. (typically in the order of 5 ppm of the VCO frequency in an analog mobile telephone system). This is done by the micro controller via the PLL control bus. Continue in step SI6.

### Step SI6: Compensate for the PLL frequency shift by decreasing the VCXO frequency by the appropriate amount.

The upwards offset of the PLL will, of course, render an instant but predictable frequency error. In order to reduce the effect of this frequency error, which may result in a "click-sound" in the speaker (which, however, may be muted by other means), it is possible to decrease the VCXO frequency by an amount, which results in the VCO frequency remaining the same, or almost the same. The amount by which the VCXO frequency should be adjusted is easily calculated since all parameters affecting the frequency error are known.

Once these two actions are taken, the AFC will take care of the final adjustment so as to keep the VCO at the correct frequency.

Continue in step SI7.

### Step SI7: Reset Freq_shifted_down flag.

Finally, when an offset has been reset, the Freq_shifted_down flag has to be reset. Go to END of routine (step SI12).

### Step SI8: Is Freq_shifted_up flag set?

If, in the first test (step SI1), it is found that the VCXO frequency cannot be increased anymore, a branch is made to a check whether the VCXO frequency has already been offset upwards. If so, an absolute limit has been reached and no further increase of the VCXO frequency is possible. Go to END of routine (step SI12). (This will only happen if a hardware failure has occurred or if the unit is being used far beyond its environmental limits). If no, continue in step SI9.

### Step SI9: Program the PLL for a frequency shift upwards.

The PLL is programmed to a small upwards offset. Continue in step SI10.

### Step SI10: Compensate for the PLL frequency shift by decreasing the VCXO frequency by the appropriate amount.

The VCXO frequency is decreased by an amount, which results in the VCO frequency remaining the same, or almost the same. Continue in step SI11.

### Step SI11: Set Freq_shifted_up flag.

Finally, when an offset has been made, the Freq_shifted_up flag has to be set. Go to END of routine (step SI12).

### Step SI12: END of 'Increase VCXO frequency' procedure.

This step terminates the 'Increase VCXO frequency'-procedure.

Fig. 3 shows a flow chart for the steps according to the invention involved in keeping the output frequency constant when the AFC and the micro controller detects a general need for tuning the VCXO frequency downwards.

As depicted in fig. 3, the 'Decrease VCXO frequency procedure' comprises very similar steps:

### Step SD0: START 'Decrease VCXO frequency' procedure.

This step initializes the 'Decrease VCXO frequency' procedure. The algorithm is entered when information about the frequency error received by the micro controller meets the criteria for decreasing the VCXO frequency.

### Step SD1: Can the VCXO frequency be decreased more?

First, a check is made whether the VCXO frequency can be decreased by the intended number of D/A-converter steps without reaching the limit. If yes, continue in Step SD2. If no, go to Step SD8.

### Step SD2: Decrease the VCXO frequency.

The VCXO frequency is decreased as intended. Continue in Step SD3.

### Step SD3: Is Freq_shifted_up flag set?

A check is made whether the PLL has been offset upwards. If yes, continue in Step SD4. If no, go to END of routine (Step SD12).

### Step SD4: Is the margin sufficient to reset the frequency shift?

A check is made whether it is time to reset this offset shift, i.e. if the margin to the upper limit has increased enough. If the margin is enough the offset will be reset (cf. steps SD5-SD7). If not, go to END of routine (Step SD12).

When a VCXO frequency decrease is to be made, the following steps shall be taken (SD5-SD7):

### Step SD5: Program the PLL for a frequency shift downwards.

The PLL is programmed to a small downwards offset. Continue in Step SD6.

### Step SD6: Compensate for the PLL frequency shift by increasing the VCXO frequency by the appropriate amount.

The VCXO frequency is increased by an amount, which results in the VCO frequency remaining the same, or almost the same.

Once these two actions are taken, the AFC will take care of the final adjustment so as to keep the VCO at the correct frequency.

Continue in Step SD7.

### Step SD7: Reset Freq_shifted_up flag.

Finally, when an offset has been reset, the Freq_shifted_up flag has to be reset. Go to END of routine (Step SD12).

### SD8: Is Freq_shifted_down flag set?

If, in the first test (Step SD1), it is found that the VCXO frequency cannot be decreased anymore, a branch is made to a check whether the VCXO frequency has already been offset downwards. If so, an absolute limit has been reached and no further decrease of the VCXO frequency is possible. Go to END of routine (Step SD12). If no, continue in Step SD9.

### Step SD9: Program the PLL for a frequency shift downwards.

The PLL is programmed to a small downwards offset. Continue in Step SD10.

### Step SD10: Compensate for the PLL frequency shift by increasing the VCXO frequency by the appropriate amount.

The VCXO frequency is increased by an amount, which results in the VCO frequency remaining the same, or almost the same. Continue in Step SD11.

### Step SD11: Set Freq_shifted_down flag.

Finally, when an offset has been made, the Freq_shifted_down flag has to be set. Go to END of routine (Step SD12).

### Step SD12: END of 'Decrease VCXO frequency' procedure.

This step terminates the 'Decrease VCXO frequency'-procedure.

The transmitted frequency may be affected by this differently depending on how the transmitter frequency is generated.

If the transmitter frequency is generated by an on-frequency PLL, the TX PLL has to be able to make as small frequency steps as the RX PLL (i.e. the previously mentioned PLL in the receive part) . In this case the connection (represented in fig. 1 by the dashed part of signal 114 between the RX PLL and the transmitter (TX) part) is non-existent.

If the transmitter frequency is generated by an offset PLL, and up-converted using the RX VCO signal as a local oscillator (represented in fig. 1 by the dashed part of signal 114 between the RX VCO and the transmitter), the change in the TX frequency will follow the change in the RX VCO, and hence be able to make as small steps as the RX VCO.

In either case there will be a permanent frequency error in the TX signal in the order of 0.5 ppm, if an offset step has been made (i.e. if either of the Freq_shifted_down or Freq_shifted_up flags have been set), which is fully acceptable.

Fig. 4 shows a typical graph of the relative frequency change versus temperature for an uncompensated crystal oscillator or a VCXO at a constant control voltage.

The output frequency f_{VCXO} of a VCXO can be changed by changing its capacitive load C_{load}, e.g. by changing the applied voltage to a varactor diode of the VCXO. The voltage control of the output frequency of the VCXO may be implemented by a processing circuit, e.g. a micro computer, using an n-bit digital to analog (D/A) converter to change the input voltage Vᵢₙ to the varactor diode of the VCXO in steps, i.e. Vᵢₙ=V_{D/A}=k(N), N=[0..2ⁿ-1], where n indicates the number of bits in the D/A converter. In fig. 4 the graph 40 represents the relative frequency change versus temperature for an uncompensated crystal oscillator or a VCXO at a constant control voltage. The graph shows the relative frequency change df/f 41 of the VCXO versus temperature T 42. An operating temperature range between Tmin and Tmax is indicated. The trimming range needed to cover the temperature range for this specific crystal is indicated by 47 (lower) and 46 (upper). The margin 48 indicates some extra trimming range needed to cover for component variations, mainly for the crystal. The shaded area 45 (exaggerated for illustrative purposes in the direction of the relative frequency axis) indicates an allowed relative frequency variation according to the relevant system specification. At temperature T1 a certain number of steps 43 of the D/A converter is needed to be able to pull the VCXO frequency into the allowed range. At the higher temperature T2, a larger number of steps 44 are needed. T2 is indicated as lying outside the operating temperature range but it might as well lie within. The relative frequency change per step of the D/A converter is assumed to be fairly constant over the relevant temperature range. This will depend on the actual VCXO design.

A table of the frequency change per D/A converter step for the relevant temperatures of the specified temperature range is recorded and stored in a memory accessible to the processing circuit. The frequency change per D/A converter step may be a constant over the relevant temperature range.

Some preferred embodiments have been shown in the foregoing, but it should be stressed that the invention is not limited to these, but may be embodied in other ways within the subject-matter defined in the following claims. For example dual (or more) mode systems having different temperature ranges of their specifications and where the system having the wider temperature range has the more relaxed frequency specifications.

## Claims

1. An electronic circuit for controlling the output frequency (114) from a frequency synthesizer (16) within a specified range of deviation from a predefined output frequency, said output frequency being based on a reference frequency (124) from a voltage controlled crystal oscillator (VCXO) (19), said circuit comprising a processing circuit (17, 20) having means for monitoring a frequency error and a D/A converter (18) for converting a digital output (122) from said processing circuit to an analog input (123) to said VCXO,
**characterized in that**
based on said frequency error and predefined conditions said processing circuit (17, 20) generates first (122) and second (125) control signals, for simultaneously
modifying the control voltage (123) to the VCXO (19) by means of said D/A converter (18) to correspondingly change the reference frequency (124) of said VCXO in such a way that the margin to the D/A converter limit is increased, and
programming the frequency synthesizer (16) in such a way that said frequency change of the VCXO is compensated, leaving said output frequency (114) from said frequency synthesizer basically unaltered.

2. An electronic circuit according to claim 1,
**characterized in that**
said frequency synthesizer (16) is implemented as a fractional-N phase locked loop (PLL).

3. An electronic circuit according to claim 1 or 2,
**characterized in that**
said reference frequency (124) of said VCXO (19) is 13 MHz or a multiple hereof.

4. A method of controlling the output frequency (114) from a frequency synthesizer (16) within a specified range of deviation from a predefined output frequency, said output frequency (114) being based on a reference frequency (124) from a voltage controlled crystal oscillator (VCXO) (19), and the reference frequency of said VCXO being regulated by a processing circuit (17, 20) that monitors a frequency error and a D/A converter (19) for converting a digital signal (122) from said processing circuit to an analog input (123) to said VCXO,
**characterized in that**
said method comprises the steps of
modifying the control voltage (123) to the VCXO (19) by means of said D/A converter (18) to correspondingly change the reference frequency (124) of said VCXO in such a way that the margin to the D/A converter limit is increased, and simultaneously
programming said frequency synthesizer (16) in such a way that said frequency change of the VCXO is compensated,
said adjustment of the reference frequency from the VCXO and said programming of said frequency synthesizer are controlled by and based on signals (122, 125) from said processing circuit (17, 20), said signals depending on said frequency error and predefined conditions.

5. A method according to claim 4,
**characterized in that**
the method of adjusting the VCXO frequency upwards comprises the steps of
Step SI0: START 'Increase VCXO frequency' procedure.
Step SI1: Can the VCXO frequency be increased more?
Step SI2: Increase the VCXO frequency.
Step SI3: Is Freq_shifted_down flag set?
Step SI4: Is the margin sufficient to reset the frequency shift?
Step SI5: Program the PLL for a frequency shift upwards.
Step SI6: Compensate for the PLL frequency shift by decreasing the VCXO frequency by the appropriate amount.
Step SI7: Reset Freq_shifted_down flag.
Step SI8: Is Freq_shifted_up flag set?
Step SI9: Program the PLL for a frequency shift upwards.
Step SI10: Compensate for the PLL frequency shift by decreasing the VCXO frequency by the appropriate amount.
Step SI11: Set Freq_shifted_up flag.
Step SI12: END of 'Increase VCXO frequency' procedure.

6. A method according to claim 4,
**characterized in that**
the method of adjusting the VCXO frequency downwards comprises the steps of
Step SD0: START 'Decrease VCXO frequency' procedure.
Step SD1: Can the VCXO frequency be decreased more?
Step SD2: Decrease the VCXO frequency.
Step SD3: Is Freq_shifted_up flag set?
Step SD4: Is the margin sufficient to reset the frequency shift?
Step SD5: Program the PLL for a frequency shift downwards.
Step SD6: Compensate for the PLL frequency shift by increasing the VCXO frequency by the appropriate amount.
Step SD7: Reset Freq_shifted_up flag.
Step SD8: Is Freq_shifted_down flag set?
Step SD9: Program the PLL for a frequency shift downwards.
Step SD10: Compensate for the PLL frequency shift by increasing the VCXO frequency by the appropriate amount.
Step SD11: Set Freq_shifted_down flag.
Step SD12: END of 'Decrease VCXO frequency' procedure.

7. A computer program comprising computer program means,
**characterized in that**,
said computer program means are adapted to perform all the steps of claim 4 when said program is run on a computer.

8. A computer program according to claim 7,
**characterized in that**
said computer program means are adapted to perform all the steps of claims 5 and 6 when said program is run on a computer.

9. A computer readable medium having a program recorded thereon,
**characterized in that**
said program when executed is to make the computer execute the method according to claim 4.

10. A dual mode cellular telephone,
**characterized in that**
it comprises an electronic circuit according to claims 1-3.
